Europäisches Patentamt

European Patent Office

Office européen des brevets

(11) Publication number: **0 193 661**
**B1**

# EUROPEAN PATENT SPECIFICATION

(45) Date of publication of patent specification: **18.07.90**

(51) Int. Cl.⁵: **H 01 L 25/04, H 05 K 7/20**

(21) Application number: **85301460.3**

(22) Date of filing: **04.03.85**

(54) Diode and connector with built-in diode.

(43) Date of publication of application:
**10.09.86 Bulletin 86/37**

(45) Publication of the grant of the patent:
**18.07.90 Bulletin 90/29**

(84) Designated Contracting States:
**DE FR GB IT SE**

(56) References cited:
**DE-A-2 212 629**
**DE-B-1 271 263**
**GB-A-2 094 796**

**PATENTS ABSTRACTS OF JAPAN, vol. 8, no. 139 (E-253) 1576r, 28th June 1984 & JP-A-59-47 748**

(73) Proprietor: **SUMITOMO ELECTRIC INDUSTRIES, LTD.**
**5-33, Kitahama 4-chome Chuo-ku Osaka-shi Osaka (JP)**

(72) Inventor: **Hayashi, Kyozo Osaka Works, Sumitomo Electric Industries, Ltd. 1-3, Shimaya 1-chome Konohana-ku Osaka (JP)**
Inventor: **Sumida, Tatsuya Osaka Works, Sumitomo Electric Industries, Ltd. 1-3, Shimaya 1-chome Konohana-ku Osaka (JP)**
Inventor: **Kawamura, Seiji Osaka Works, Sumitomo Electric Industries, Ltd. 1-3, Shimaya 1-chome Konohana-ku Osaka (JP)**
Inventor: **Morikawa, Hisashi Osaka Works, Sumitomo Electric Industries, Ltd. 1-3, Shimaya 1-chome Konohana-ku Osaka (JP)**

(74) Representative: **Rackham, Stephen Neil et al GILL JENNINGS & EVERY 53-64 Chancery Lane London WC2A 1HN (GB)**

## Description

The present invention relates to a diode and a connector with built-in diode, and, more particularly, to a structure of a connecting portion between an electrode on the PN junction plane side of a diode element and an external terminal or of an external terminal on the PN Junction plane side thereof.

Prior Art (I)

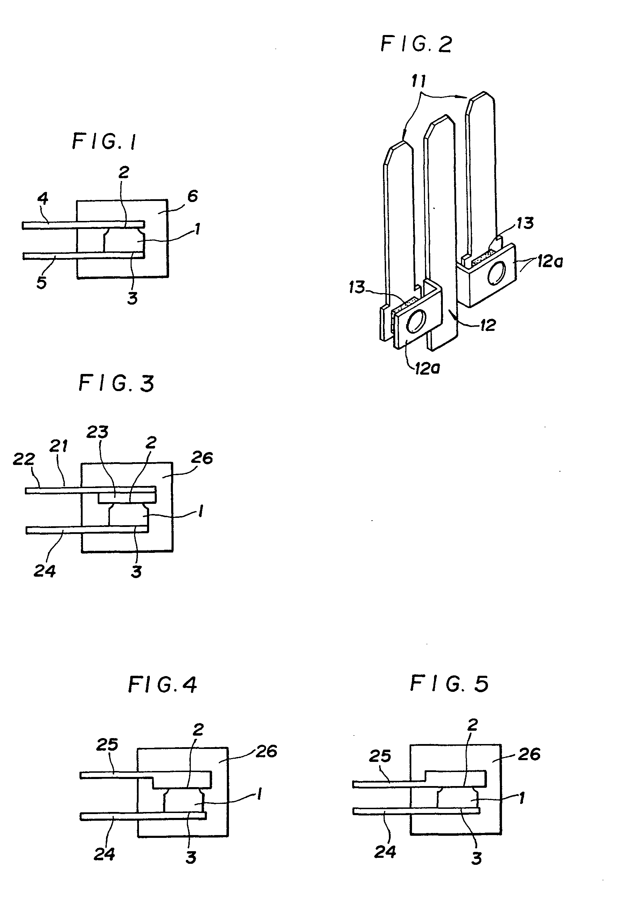

A conventional diode of the structure shown in Figure 1, which is generally similar to that shown in JP—A—59—172753 includes a diode element 1 having an electrode on each of a face 2 on the PN junction plane side and a face 3 on the side opposite to the PN junction plane thereof, external terminals 4 and 5 are connected in face-to-face contact with the electrodes on the faces 2 and 3, respectively, and a resin moulding 6 is formed to surround at least the diode element 1, the external terminals 4 and 5 are conventionally made of a sheet material so as to have the same thickness as shown in Figure 1.

The conventional diode of the structure shown in Figure 1 has a disadvantage described below. When an instantaneous large current such as a surge current flows in the diode, heat is developed in the diode element particularly along the PN junction plane of the diode element 1. The heat thus developed is absorbed by the nearest portion of the diode element 1 because of the limitation in the heat conductivity depenent upon the material of the external terminal. In the diode of the conventional structure without sufficient heat absorbing material in the neighbourhood of the PN junction plane, the diode element has insufficient resistance to heat and is susceptible to damage by the heat.

Prior Art (II)

Recently a specification has been published JP—A—60—96827 which describes a connector with a built-in diode to be included in, for example, a harness for automobile. There is a tendency for smaller size and lighter weight in relation to the demand for smaller and lighter harnesses. This tendency has presented a problem of insufficient thermal capacity of a male connector terminal. This conventional connector with a built-in diode is generally similar to the structure shown in Figure 2 which is an earlier proposal of the applicants and in which a male side connector has a diode element 13 attached between each of input terminal 11 and an output terminal 12, and the attachment portion of each of the element is inserted into a housing and fixed by a resin of epoxy series. The input terminal 11 is flat and has a substantially uniform width. The output terminal 12 is of, in the case of the structure comprising one each of the input and the output terminals, L-shape having a projection on one edge of the lower portion thereof for attachment of the diode element and of, in the case of the structure comprising two input terminals and one output terminal, T-shape having a projection 12a on each of the opposite edges of the base portion thereof as shown in Figure 2. The central portion of the projection 12a is slightly protruded in a circle toward the input terminal 11 to facilitate the soldering of the diode element 13 thereto.

In the conventional structure of the connector described above, each of the terminals has large size and area and a sufficient thermal capacity to maintain the characteristic property of the diode element. Accordingly, these terminals can be incorporated in a circuit through a fuse without any specific problem.

With the recent trend for smaller size of the terminal, however, the thermal capacity of the terminal has become smaller. The smaller thermal capacity of the terminal has presented various problems described below.

Electric current is applied to the input terminals 11 and flows out of the output terminal 12. If there is a short in a circuit including a connector, a large current flows through the circuit until the fuse is blown, to develop heat on the side of the diode closest its PN junction that is, on the side attached to the input terminal in an N-type diode or on the side attached to the output terminal in a P-type diode. If this heat flows to the terminal and is radiated thereby there will be no problem. However, if the terminal has only a small thermal capacity, the heat is not radiated sufficiently and raises the temperature of the diode element, to thereby damage the element or melt the solder in the attachment portion away and spoil the connector. The damage of the diode causes loss of directivity of the current in the circuit and malfunction of other devices.

Insufficient holding force of the male connector terminal is another problem. In the conventional diode structure, as shown in Figure 2, one terminal, mostly the input terminal, of the diode element 13 is formed flat. Accordingly, as the terminal becomes smaller in size to decrease the area of its attachment with the moulding resin, the resistance of the flat terminal to drawing force is reduced, to thereby make it possible that the terminal comes out of the housing upon its disengagement from the female connector.

Other prior art documents are GB—A—2084796 in which a semiconductor device an external terminal lead includes a flat paddle like portion to which the semiconductor is connected to improve its heat sinking ability. DE—B—1271263 discloses an arrangement for cooling a PN junction surrounded by a moulded resin body in which the terminals outside the resin body are of comb-like form to increase their surface area and hence improve their heat sinking ability.

According to this invention a diode comprises a diode element having an electrode on the side of the diode element closest to its pn junction, and on the opposite side, external planar terminal strips connected to each of the electrodes in face to face contact with the diode elements the external planar terminal strip connected to the

electrode on the side of the diode element closest to the pn junction including a heat sink portion adjacent the diode element formed by increasing the extent of the terminal strip in its thickness direction.

A diode in accordance with this invention is adapted to radiate the heat developed on the PN junction plane to thereby limit termperature rise in the attachment portion. The invention can be used with diodes of P-type or N-type. A further advantage of the present invention is that the pull-out resistance of the terminals is also improved.

In a connector with built-in diode according to the present invention, a diode element is connected between an input terminal and an output terminal, a terminal base portion including the element is embedded by resin molding in a housing, and at least the base of the terminal on the PN junction side of the diode element is provided with a heat sink portion for increasing the thermal capacity of the terminal.

In a connector with built-in diode according to an embodiment of the present invention, the heat sink portion is formed in an L-shape integral with the side of the base of the terminal on the PN junction side. Alternatively, the heat sink portion is formed in a bent shape at the base portion of the terminal on the PN junction side to provide it with also a function to prevent accidental disengagement from the housing.

The invention will be better understood from the following description taken in connection with the accompanying drawings in which:

Fig. 1 is a schematic illustration of a conventional diode having external terminals of the same thickness;

Fig. 2 is a perspective view of terminals and diode elements of a conventional connector with built-in diode;

Fig. 3 is a schematic illustration of a diode according to the present invention, in which the external terminal on the PN junction plane side comprises a terminal plate and a heat sink;

Figs. 4 and 5 are schematic illustrations of diodes according to the present invention, in which the external terminal on the PN junction plane side is of an integral stepped configuration;

Fig. 6 is a perspective view of a diode according to the present invention having a terminal of a stepped material;

Fig. 7A is a perspective view showing essential portions of a diode having a heat sink according to the present invention;

Fig. 7B is a perspective view showing schematic structure of the diode having the heat sink according to the present invention;

Fig. 8 is a perspective view showing schematic structure of a diode having an opposite semiconductor type to that of Fig. 7B;

Fig. 9 is a perspective view of terminals and diode elements used in the connector with built-in diode according to the present invention;

Fig. 10 is a plan view of the terminals and diode elements of Fig. 9 in the assembled state;

Fig. 11 is a partially sectional side view of the connector with built-in diode according to the present invention before application of resin molding;

Fig. 12 is a partially cross sectional plan view of the connector with built-in diode shown in Fig. 11;

Fig. 13 is a perspective view of terminals and diode elements used in the connector with built-in diode and having heat sinks according to the present invention;

Fig. 14 is a plan view of the terminals and diode elements of Fig. 13 in the assembled state; and

Fig. 15 is a sectional view of the connector with built-in diodes and having heat sinks according to the present invention.

Certain perferred embodiments of the present invention will now be described in detail with reference to the drawings.

Embodiment I

Fig. 3 shows a diode according to the embodiment of the present invention, in which the diode element 1 has an electrode on each of the face 2 on the PN junction plane side and the face 3 on the side opposite to the PN junction plane side, as in the diode element shown in Fig. 1. An external terminal 21 connected to the electrode on the PN junction plane side comprises a terminal plate 22 and a heat sink 23. The terminal plate 22 is formed of an alloy of copper and iron, and the heat sink 23 is formed of copper which has a high thermal conductivity and is low in cost. The terminal plate 22 and the heat sink 23 are bonded conductively to each other and are so disposed that the heat sink 23 is in contact with the face of the diode element 1 on the PN junction plane side.

An external terminal 24 is formed of a single plate as in the terminal plate 22 and connected to the electrode on the face 3 on the side opposite to the PN junction plane. The external terminal 21 on the PN junction plane side may be, instead of the above-described structure, of the form of a stepped external terminal 25 of an alloy of copper and iron having a heat sink formed integrally therewith as shown in Fig. 4. In this alternative form, the external terminal 25 is larger in thickness in the portion in contact with the PN junction plane side. The stepped terminal 25 may be used in opposite direction as shown in Fig. 5. The alloy copper and iron is higher in workability and strength than copper. The diode element 1 and the two external terminals 21 or 25 are surrounded by a resin molding 26 to form an integral diode therewith with the external terminals exposed to the outside only in the tip ends thereof.

For use of this diode with a wire harness for automobile, the exposed portions of the external terminals 21 or 25 and 24 and the resin molding 26 may be adapted in shape for direct fitting with the connector of the wire harness for automobile.

In the diode of the structure according to the embodiment of the present invention, the heat instantaneously developed mainly on the PN junction plane of the diode element by an instantaneous large current such as surge current is diffused three-dimensionally by the heat sink 23 of copper disposed in contact with the face 2 on the PN junction plane or by the stepped portion of large thickness of the external terminal 25 of an alloy of copper and iron. Therefore, the diode according to the embodiment of the present invention is capable of absorbing effectively the heat developed therein.

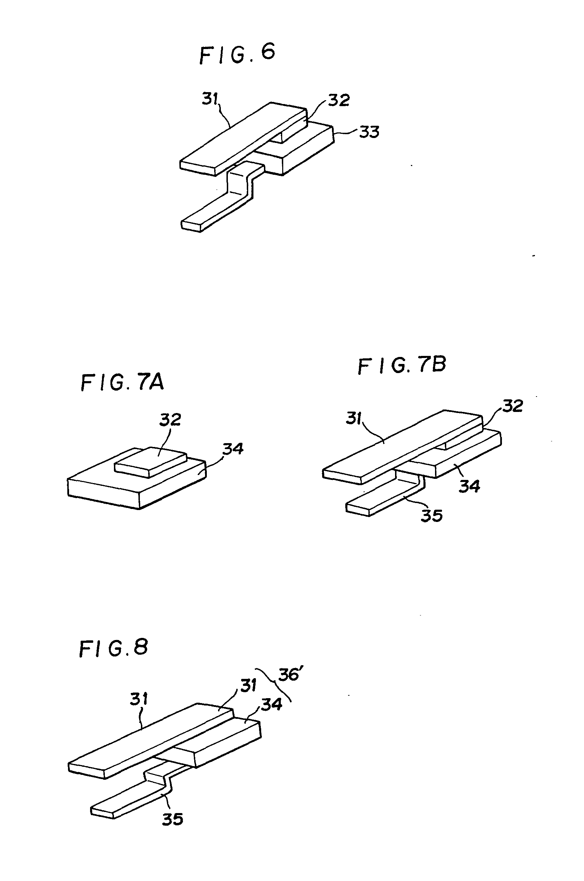

Fig. 6 shows a diode according to another embodiment of the present invention of the substantially identical structure with the diode shown in Fig. 4, with the resin molding removed.

A diode according to Fig. 6 has an external terminal 31 connected to one electrode on the upper side and a terminal of a stepped material 33 cut from, for example, a nickel-plated alloy of copper and iron and connected by bonding to the other electrode on the PN junction plane side. The stepped terminal 33 is used because it has a large heat radiation effect.

The diode of the structure shown in Fig. 6 (or Fig. 4 or Fig. 5) has certain disadvantages as follows:

(a) While the thick stepped terminal 33 is used as the electrode on the PN junction side of the diode element 32 to increase the heat radiation effect, in a diode of opposite semiconductor type requiring tip ends (connecting portions) of the external terminals of the diode to be interchanged for proper fitting with, for example, a female connector, such as a diode of opposite semiconductor type to that of the diode shown in Fig. 6, requiring an external terminal having the same tip end as that of the stepped terminal 33 for one electrode of the diode element 32 and an external terminal having the same tip end as that of the external terminal 31 for the other electrode on the side of the diode closest to its PN junction 32, the shape of each of both the terminals must be changed in consideration of the heat radiation effect.

(b) Since the terminal of a stepped material is used in this conventional diode, the high cost of the stepped material makes it difficult to reduce the cost of the diode itself.

Fig. 7B is a perspective view of the diode according to the present invention, further improved from the diode shown in Fig. 6. The diode of Fig. 7B has the substantially identical structure with the diode of Fig. 3, with the resin molding removed.

Throughout Figs. 7A, 7B and 8, identical reference numerals are used to designate identical parts, wherein 34 denotes a heat sink formed of, for example, a nickel-plated alloy of copper and iron, and 35 denotes a conductive terminal connected by bonding to the heat sink 34. An external terminal 36 has the heat sink 34 and the conductive terminal 35. The diode according to this embodiment uses the heat sink 34 and the conductive terminal 35 instead of the stepped electrode 33. First of all, as shown in Fig. 7A, the heat sink 34 of, for example, a nickel-plated alloy of copper and iron, is bonded to the electrode on the PN junction plane side of the diode element 32. Thereafter, as shown in Fig. 7B, the external terminal 31 is bonded to one electrode of the diode element 32 and the conductive terminal 35 is bonded to the heat sink 34 bonded to the other electrode (on the PN junction plane side) of the diode element 32. That is, in the diode according to the embodiment of the present invention, the heat sink is bonded beforehand to the electrode on the PN junction plane side of the diode element 32, and then the conductive terminal 35 is connected by bonding to the heat sink 34 and the external terminal 31 is connected by bonding to the electrode on the other side of the diode element 32.

For applying the present invention to articles of opposite semiconductor type, the heat sink 34 to which the diode element 32 shown in Fig. 7A is bonded is reversed in direction and, thereafter, the external terminal 31 and the electroconductive terminal 35 are bonded to the heat sink 34 and the electrode remote from its PN junction side of the diode element 32, respectively. In the case of Fig. 8, the external terminal 31 functions as an electroconductive terminal and forms a new external terminal 36' on the PN junction plane side in cooperation with the heat sink 34. The electroconductive terminal 35 functions as an external terminal.

The diode according to the above-described embodiment of the present invention including the heat sink as shown in Figs. 3, 7b and 8 has the following meritorious effects in comparison to the diode according to the embodiment shown in Figs. 5 and 6;

(a) It requires only a lower cost of material because terminals of stepped material are not used in it.

(b) For applying the diode according to this embodiment of the present invention to a diode of opposite semiconductor type it is required only to reverse the direction of the heat sink to which the diode element is bonded and thereafter to bond the electroconductive terminal and the external terminal identical with those of the diode according to this embodiment to the diode element and the heat sink, respectively. Therefore, a set of terminals identical with the external terminal and the electroconductive terminal according to this embodiment can cope with the diode of the reverse polarity.

(c) Since the heat sink is formed independently of the conductive terminal, no consideration for heat radiation effect is required in designing the terminals.

(d) A diode having a plurality of diode elements can be produced easily.

Results of experiments of the diodes according to the embodiments of the present invention will now be described. A conventional diode, in which two external terminals having the same thickness and the thermal capacity of 0.15 J/K in total were connected to electrodes of a diode element (1.95 mm × 1.95 mm × 300 µm) and entirely surrounded by a resin molding except in tip ends thereof, was damaged by the heat of total 16.3 J for 190 m sec. The diode according to the embodiment of the present invention using the external terminal having a heat sink on the PN junction plane side and having the heat capacity of 0.35 J/K endured the heat of total 103 J for 1 sec. and failed at the heat of total 132 J for 1.2 sec. A commercially obtained diode including external terminals made of an alloy of copper and zinc having the same thickness as and a larger area than the above-mentioned conventional diode, to provide the thermal capacity of 0.85 J/K was damaged at the heat of total 68.9 J for 820 m sec.

The diodes according to the embodiment of the present invention have the meritorious effect that the heat instantaneously developed mainly on the PN junction plane of the diode element by an instantaneous large current such as surge current is diffused three-dimensionally by the heat sink portion of the external terminal disposed in contact with the face on the PN junction plane side, whereby the heat is effectively absorbed and the damage of the diode element is prevented.

Embodiment II

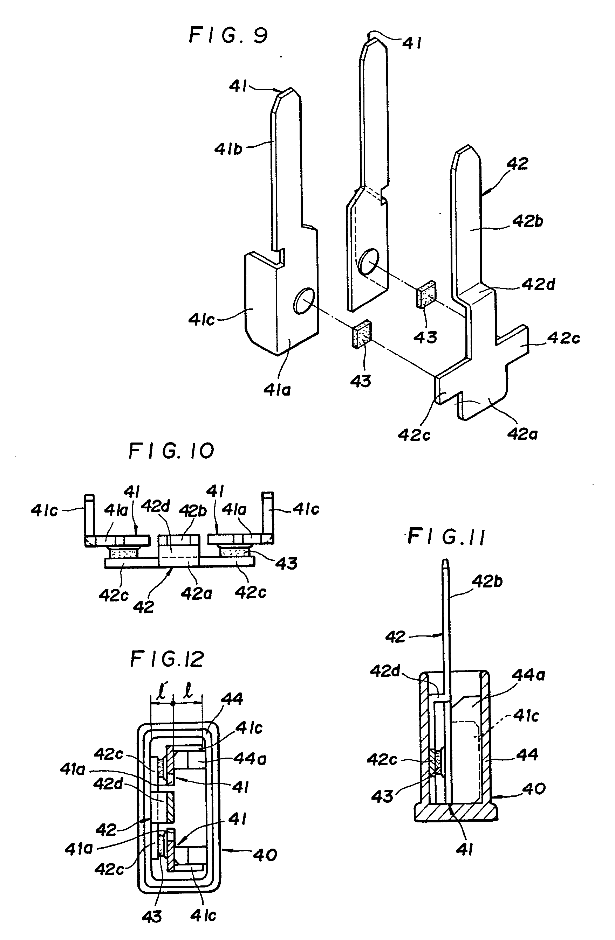

Fig. 9 is an exploded perspective view of terminals and diode elements for use in the connector with built-in diode according to the second embodiment of the present invention, in which the connector with built-in diode comprises two input terminals 41 each having a base portion 41a which is to be embedded within the housing and is formed to have a larger width than a plug portion 41b which is the tip end of the input terminal 41. The base portion 41a has on an edge thereof a heat sink 41c extending in the thicknesswise direction of the terminal and integral therewith. The base portion 41a has an L-shaped cross section with the heat sink 41c. The base portion 41a is projected in the center thereof slightly in a circle towards an N type diode element 43 to facilitate the soldering of the element 43. The base portion 41a is soldered to the face of the diode element 43 closest to its PN junction.

An output terminal 42 has a base portion 42a which is provided thereon a face edge thereof with a projection 42c for bonding thereon a face remote from the PN junctions of the N-type diode elements 43. The output terminal 42 has a stepped portion 42d formed in the intermediate portion thereof for alignment of a plug portion 42b on the tip end thereof with the plug portion 41b of the input terminal 41. While the stepped portion 42d may be disposed, as in the conventional output terminal shown in Fig. 2, at the base end of the projection 42c, it is more advantageous to provide the stepped portion 42d at the position shown in Fig. 9 to widen the base portion 41a of the input terminal 41 inwards to thereby increase the heat radiation effect and prevent increase of the width of the connector.

As shown in Fig. 10, the N-type diode element 43 is soldered between the base portion 41a of each of the input terminals 41 and the projection 42c of the output terminal 42. Further, as shown in Fig. 11, the entire structure shown in Fig. 10 is inserted into a housing 44 and a resin molding material of, for example, epoxy series is filled in the space within the housing 44, to thereby complete a connector 40 with built-in diode according to the second embodiment of the present invention.

The housing 44 is usually provided therein with a terminal positioning rib 44a. In this case, as shown in Fig. 12, the heat sink 41c of the input terminal 41 extends along the outer surface of the rib 44a. By making the extension length l larger than the distance l' between the front face of the rib 44a and the inside wall of the housing 44 opposite to said front face, the terminal is effectively prevented from being inserted reversely into the housing 44. That is, when the terminal is inserted into the housing 44 in the direction reverse to that of Fig. 12, the base protion 41a of the input terminal 41 collides with the rib 44a to thereby prevent erroneous insertion of the terminal.

The connector with built-in diode according to the embodiment of the present invention has the meritorious effects described below.

(a) Since the heat sink is attached to the terminal on the PN junction side of the diode element to increase the thermal capacity and the heat radiation effect, a small-sized terminal can protect the diode element and its attachment portion from the heat at short-circuit and increase the value of the current passing through the terminal.

(b) Since the radiator piece can be used as a member to prevent reverse insertion of the terminal into the housing, erroneous incorporation of the terminal can be prevented.

Embodiment III

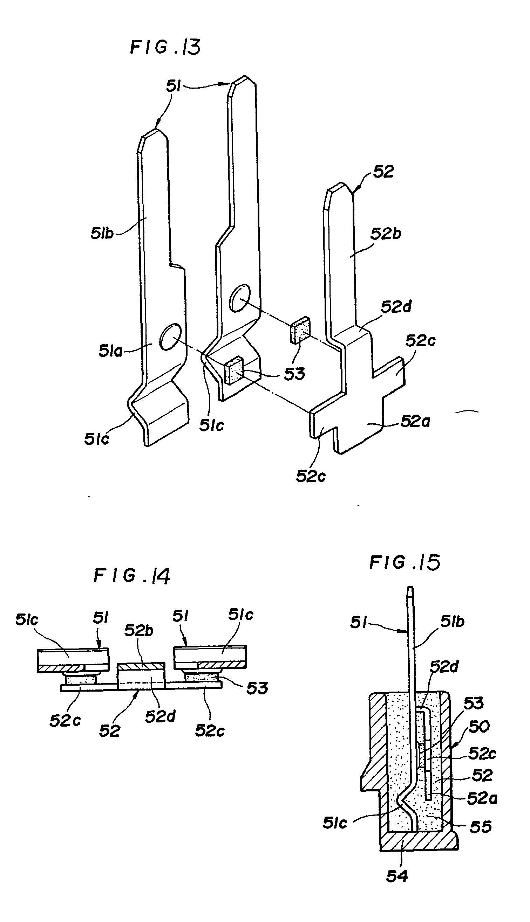

Fig. 13 is an exploded perspective view of terminals and diode elements for use in the connector with built-in diode according to another embodiment of the present invention, in which the connector with built-in diode comprises two inpout terminals 51 each having a base portion 51a which is to be embedded within the housing and is formed to have a larger width than a plug portion 51b which is the tip end of the input terminal 51. The input terminal 51 has at the tip end of the base portion 51a thereof an integrally formed heat sink 51c bent in V-shape in the thicknesswise direction. Since an output terminal 52 of this embodiment is identical in shape to the output terminal 42 described with reference to Fig. 9, further description of the output terminal 52 will be unnecessary. Reference numerals 42a, 42b, 42c, 42d and 43 of Fig. 9 correspond to reference numerals 52a, 52b, 52c, 52d and 53 of Fig. 13, respectively.

As shown in Fig. 14, the N-type diode element 53 is soldered between the base portion 51a of each of the input terminals 51 and the projection 52c of the output terminal 52. Further, as shown in Fig. 15, the entire structure shown in Fig. 14 is inserted into a housing 54 and a resin molding material 55 of, for example epoxy series is filled in the space within the housing 54, to thereby complete a connector 50 with built-in diode according to the third embodiment of the present invention.

The connector with built-in diode according to the above embodiment of the present invention provides the meritorious effects described below.

(a) Since the terminal is provided at the base portion thereof on the PN junction side of the diode element with the heat sink bent in the thicknesswise direction of the terminal, the thermal capacity of the terminal is increased thereby and heat radiation is promoted. Accordingly, the diode element and its attachment portion can be protected from the heat at the time of short circuit and the entire structure can be made smaller without decreasing reliability.

(b) Even when the terminal is smaller in size, it is prevented by the action of the heat sink from accidental disengagement from the housing.

While the connectors according to the embodiments of the present invention have been described with respect to the structure in which a diode element is bonded between each of two input terminals and a common output terminal, those skilled in the art will readily understand that the present invention is applicable to a connector comprising an input terminal, an output terminal and a diode element held between said input and output terminals.

In the case where a P-type diode element is bonded to the terminal in any of the second and third embodiments of the present invention, the heat sink is provided on the output terminal.

## Claims

1. A diode comprising a diode element (1, 32, 43, 53) having an electrode (2) on the side of the diode element closest to its pn junction, and (3) on the opposite side, external planar terminal strips (24, 25, 31, 35, 41, 42, 51, 52) connected to each of the electrodes (2, 3) in face to face contact with the diode elements (1, 32, 43, 53) the external planar terminal strip (22, 25, 31, 35, 41, 51) connected to the electrode (2) on the side of the diode element closest to the pn junction including a heat sink portion (23, 33, 34, 41c, 51c) adjacent the diode element (1, 32, 43, 53) formed by increasing the extent of the terminal strip in its thickness direction.

2. A diode according to claim 1, in which the terminal strip (24, 25, 31, 35, 41, 51) connected to the electrode (2) on the side of the diode element closest to the pn junction has a greater extent in the thickness direction than the terminal strip (24, 31, 35, 42, 52) connected to the terminal (3) on said opposite side.

3. A diode according to claim 2, in which the heat sink portion (23, 34) is conductively bonded onto the planar terminal strip (22, 35) to produce a heat sink portion having a greater thickness than the remainder of the planar terminal strip.

4. A diode according to claims 1 or 2, in which the heat sink portion (25, 33) is formed integrally with the remainder of the external planar terminal strip (25, 35), the heat sink portion having a greater thickness than the remainder of the external planar terminal strip.

5. A diode according to claim 1 or 2, in which the heat sink portion (41a, 41c, 51a, 51c) is formed by increasing the width of the terminal strip (41b, 51b) adjacent the diode element (43, 53) and bending this portion of increased width out of the plane containing the remainder of the terminal strip (41, 51) to increase its extent in the thickness direction of the terminal strip.

6. A diode according to claim 5, in which the terminal strip in the region of the heat sink portion is formed with an L-shaped cross-section (41a, 41c).

7. A diode according to claim 5, in which the terminal strip is bent into a V-shape (51c).

8. A connector with a built in diode comprising a diode in accordance with any one of the preceding claims in which the external planar terminal strips form input and output terminals and in which the diode element (1, 32, 43, 53) is contained within a resin moulding (26, 44, 50).

9. A connector according to claim 8 when dependent upon claim 6, in which the housing is hollow and includes a positioning rib extending from one side of the inside wall of the housing towards the opposite side and in which the separation (L') between the positioning rib and the opposite side of the inside wall is less than the length of the bent portion (41c) forming the heat sink so that the diode can only be inserted into the housing with the heat sink portion (41c) extending beside the positioning rib (44a).

## Patentansprüche

1. Diode mit einem Diodenelement (1, 32, 43, 53), das eine Elektrode (2) auf der Seite des Diodenelements, die seinem pn-Übergang am nächsten liegt, und eine Elektrode (3) auf der gegenüberliegenden Seite hat, und mit externen planaren Anschlußstreifen (24, 25, 31, 35, 41, 42, 51, 52), die mit jeder der Elektrode (2, 3) unter Ausbildung eines Oberflächenkontakts mit den Diodenelementen (1, 32, 43, 53) verbunden sind, wobei der externe planare Anschlußstreifen (22, 25, 31, 35, 41, 51), der mit der Eleketrode (2) auf der Seite des Diodenelements verbunden ist, die dem pn-Übergang am nächsten liegt, ein Wärmeableitteil (23, 33, 34, 41c, 51c) benachbart dem Diodenelement (1, 32, 43, 53) einschließt, das durch Vergrößern des Maßes des Anschlußstreifens in Richtung seiner Dicke ausgebildet ist.

2. Diode nach Anspruch 1, bei der der Anschlußstreifen (24, 25, 31, 35, 41, 51) der mit der Elektrode (2) auf der Seite des Diodenelements, die dem pn-Übergang am nächsten liegt, verbunden ist, ein größeres Maß in Richtung der Dicke als der mit der Elektrode (3) auf der gegenüberliegenden Seite verbundene Anschlußstreifen (24, 31, 35, 42, 52) hat.

3. Diode nach Anspruch 2, bei der das Wärmeableitteil (23, 24) auf dem planaren Anschlußstreifen (22, 35) leitend anhaftet, um ein Wärmableitteil mit einer größeren Dicke als der Rest des planaren Anschlußstreifens zu erzeugen.

4. Diode nach Anspruch 1 oder 2, bei der das Wärmeableitteil (25, 33) einstückig mit dem Rest des externen planaren Anschlußstreifens (25, 35) ausgebildet ist, wobei das Wärmeableitteil eine größere Dicke als der Rest des externen planaren Anschlußstreifens aufweist.

5. Diode nach Anspruch 1 oder 2, bei der das Wärmeableitteil (41a, 41c, 51a, 51c) ausgebildet ist durch Vergrößern der Breite des Anschlußstreifens (41b, 51b) in der Nähe des Diodenelements (43, 53) und Herausbiegen dieses Teils mit vergrößerter Breite aus der Ebene, die den Rest des Anschlußstreifens (41, 51) einschließt, um sein Maß in Richtung der Dicke des Anschlußstreifens zu vergrößern.

6. Diode nach Anspruch 5, bei der der Anschlußstreifen im Bereich des Wärmeableitteils mit L-förmigem Querschnitt (41a, 41c) ausgebildet ist.

7. Diode nach Anspruch 5, bei der der Anschlußstreifen zu einer V-Form (51c) gebogen ist.

8. Verbinder mit eingebauter Diode, der eine Diode entsprechend einem der vorhergehenden Ansprüche aufweist, bei dem die externen planaren Anschlußstreifen Eingangs- und Ausgangsklemmen ausbilden und bei dem das Diodenelement (1, 32, 43, 53) in einem Kunststoffpreßteil, (26, 44, 50) enthalten ist.

9. Verbinder nach Anspruch 8, falls abhängig vom Anspruch 6, bei dem das Gehäuse hohl ist und eine Positionierrippe einschließt, die sich von einer Seite der Innenwand des Gehäuses zur gegenüberliegenden Seite erstreckt, und bei dem der Abstand (L') zwischen der Positionierrippe und der gegenüberliegenden Seite der Innenwand geringer als die Länge des den Wärmeableiter bildenden gebogenen Teils (41c) ist, so daß die Diode nur dann in das Gehäuse eingesetzt werden kann, wenn das Wärmeableitteil (41c) neben der Positionierrippe (44a) verläuft.

**Revendications**

1. Une diode comprenant un élément de diode (1, 32, 43, 53) comportant une électrode (2) sur le côté de l'élément de diode le plus proche de sa jonction pn, et (3) sur le côté opposé, des bandes de borne planes externes (24, 25, 31, 35, 41, 42, 51, 52) reliées à chacune des électrodes (2, 3) en contact face à face avec les éléments de diode (1, 32, 43, 53), la bande de borne plane externe (22, 25, 31, 35, 41, 51) reliée à l'électrode (2) sur le côté de l'élément de diode le plus proche de la jonction pn comportant une portion d'abaissement de chaleur (23, 33, 34, 41c, 51c) adjacente à l'élément de diode (1, 32, 43, 53) formée en augmentant l'étendu de la bande de borne dans la direction de son épaisseur.

2. Une diode selon la revenidcation 1, dans laquelle la bande de borne (24, 25, 31, 35, 41, 51) reliée à l'électrode (2) sur le côté de l'élément de diode le plus proche de la jonction pn a une étendue supérieure dans la direction de l'épaisseur à la bande de borne (24, 31, 35, 42, 52) reliée à la borne (3) au côté opposé.

3. Une diode selon la revendication 2, dans laquelle la portion d'abaissement de chaleur (23, 34) est liée conductivement à la bande de borne plane (22, 35) pour produire une portion d'abaissement de chaleur ayant une épaisseur supérieure au restant de la bande de borne plane.

4. Une diode selon la revendication 1 ou 2, dans laquelle la portion d'abaissement de chaleur (25, 35) est formée intégralement avec le restant de la bande de borne plane externe (25, 35), la portion d'abaissement de chaleur ayant une épaisseur supérieure au restant de la bande de borne plane externe.

5. Une diode selon la revendication 1 ou 2, dans laquelle la portion d'abaissement de chaleur (41a, 41c, 51a, 51c) est formée en augmentant la largeur de la bande de borne (41b, 51b) adjacente à l'élément de diode (43, 53) et liant cette portion de largeur augmentée hors du plan contenant le restant de la bande de borne (41, 51) pour augmenter son étendue dans la direction d'épaisseur de la bande de borne.

6. Une diode selon la revendication 5, dans laquelle la bande de borne dans la région de la portion d'abaissement de chaleur est formée avec une section transversale en L (41a, 41c).

7. Une diode selon la revendication 5, dans laquelle la bande de borne est pliée en V (51c).

8. Un connecteur à diode incorporée comprenant une diode selon l'une des revendications précédentes dans lequel les bandes de borne planes externes forment des bornes d'entrée et de sortie et dans lequel l'élément de diode (1, 32, 43, 53) est contenu dans un moule de résine (26, 44, 50).

9. Une connecteur selon la revendication 8 lorsque dépendante de la revendication 6, dans lequel le boîtier est creux et comprend une nervure de positionnement s'étendant d'un côté de la paroi interne du boîtier vers le côté opposé et dans lequel la séparation (L') entre la nervure de positionnement et le côté opposé de la paroi interne est inférieure à la longueur de la portion pliée (41c) formant l'abaisseur de chaleur de façon que la diode puisse seulement être insérée dans le boîtier avec la portion d'abaissement de chaleur (41c) s'étendant à côté de la nervure de positionnement (44a).

FIG. 1

FIG. 2

FIG. 3

FIG. 4

FIG. 5

FIG. 6

FIG. 7A

FIG. 7B

FIG. 8

F I G. 9

F I G. 10

F I G. 11

F I G. 12

FIG. 13

FIG. 14

FIG. 15